# EUROPEAN PATENT SPECIFICATION

(11) **EP 2 657 159 B1**
(45) Date of publication and mention of the grant of the patent: **27.02.2019**
(21) Application number: 11851741.6
(22) Date of filing: 22.12.2011
(51) Int. Cl.: B65G 47/51, H05K 13/00

(54) **COMPONENT SUPPLY DEVICE AND COMPONENT SUPPLY METHOD**
KOMPONENTENZUFUHRVORRICHTUNG UND KOMPONENTENZUFUHRVERFAHREN
DISPOSITIF ET PROCÉDÉ D'ALIMENTATION EN COMPOSANTS

(30) Priority: 24.12.2010 JP 2010288336
(43) Date of publication of application: 30.10.2013
(73) Proprietor: Yazaki Corporation, Minato-ku Tokyo 108-8333 (JP)
(72) Inventor: TSUCHIYA, Takayuki, Makinohara-shi Shizuoka 421-0407 (JP); KATSUYAMA, Hiroaki, Makinohara-shi Shizuoka 421-0407 (JP); KAWAI, Toshio, Toyohashi-shi Aichi 440-0832 (JP)
(74) Representative: Grünecker Patent- und Rechtsanwälte PartG mbB
(86) International application number: PCT/JP2011/079800
(87) International publication number: WO 2012/086751

(56) References cited:
- GB-A- 2 254 604
- JP-A- 2001 198 193
- JP-A- 2001 198 194
- JP-A- 2001 198 194
- JP-A- 2001 199 508
- JP-A- 2001 258 997
- JP-A- 2005 280 971
- US-A- 4 488 662

## Description

### [Technical Field]

The present invention relates to a component supply device and a component supply method for supplying components such as a connector housing by inclining a stick which receives the components forward and downward and sliding the components along the stick.

### [Background Art]

Conventionally, various component supply devices are disclosed so as to supply components such as electronic parts or a connector to the next step.

For example, the PTL 1 discloses a component supply device including a rectangular tube-shaped stick. The stick having a projection for reducing friction in the inner surface is inclined in backward and upward directions toward a flat printed circuit board positioned in the front side. In the stick, a small transformer as an electronic component is inserted from the rear, and then supplied on the printed circuit board by air pressure.

Furthermore, the PTL 2 discloses a component supply device. The component supply device opens a front wall slit of a tube stock portion at a bottom required tube position. The tube stock portion arranges multiple tiers tubes which receives a plurality of connectors by type of the connector in multiple lines. Then, the connector is moved from the required tube to a pick-up palette by air pressure, and the pick-up palette is moved along a horizontal rail to an electric wire crimping process being next process.

### [Citation List]

### [Patent Literature]

[PTL 1] Japanese Patent Publication No. H10-224083 (FIG.1)
[PTL 2] Japanese Patent Publication No. 2007-1756 (FIG.1)

Document GB 2 254 604 A relates to a merchandising system for the supply of orders (e.g. in a supermarket or a warehouse) comprising a plurality of storage units 2 each for holding a stack of products. Dispensing means 26 are associated with the stacks, for dispensing products 29 therefrom. A computer and means for inputting details of the order to be supplied are provided, the computer being operatively associated with the dispensing means 26 so as to effect automatic operation thereof to dispense products as required to satisfy the order. Preferably the chutes have bristles for slowing the articles being dispensed. Preferably the chutes have their tops arcuately arranged to allow easy refilling. The chutes may feed an outlet chute and a belt conveyor leading to a packing and collection station.

Document JP 2001 198194 A relates to a drug storage device allowing taking out drugs by only single action, returning the drugs without disturbing their rows, and appropriately grasping the storage states. This drug storage device is provided with a lot of cassettes 20 for storing the drugs 1 in the aligned states and a support means 10 holding the cassettes 20 in the aligned states. The cassette 20 is formed with an exit/ entrance 21 allowing taking out the drugs 1 and pushing them thereinto, and an energizing means 22 energizing the stored drugs 1 toward the exit/entrance 21 is added thereto. The support means 10 holds the cassette 20 with the exit/ entrance 21 exposed. Counting means 41, 42, 30 for
finding the number of drugs 1 stored in the cassette 20 are provided so that the drugs can be directly taken in/out from the cassette by hands, and the drugs in the respective cassettes are automatically counted. A drug rack and a drug cart are provided so as to reduce the restriction in the establishment, forming of a supplement port can facilitate a batch supplement, and the real-time output can make the drug administration precise.

Document US 4488662 discloses a component supply device according to the preamble of claim 1.

### [Summary of Invention]

### [Technical Problem]

In each of the above conventional component supply device, it is required to have a device including an air pressure supply route, an air pressure switching/adjusting portion, and an air pressure generating portion so as to press components by air pressure in a supplying direction. As a result, the structure of the component supply device becomes complex. Thus, the size and cost increase.

Furthermore, in the component supply device disclosed in the PTL 2, the tube as a stick for supplying the connector is arranged with multiple tiers. For this reason, since the connector is detected by the sensor in the receiving palette, it is difficult to detect the presence or absence of the connector in the tube. Thus, when the bottom tube is empty, s work that replacing the tube of empty with the tube in which the connector is inserted can not be efficiently performed.

Moreover, the structure of the component supply device is increased by arranging the tube for supplying the connector in a plurality of lines depending on the type of connector. For example, a case that one type of the connector or component is
continuously supplied and then the other type of the connector or component is continuously supplied is unsuitable for the component supply device.

Accordingly, the present invention is to provide a component supply device and a component supply method which can have simple structure, reduce the size and cost, surely detect that the stick becomes empty, efficiently replace the empty stick with the stick including the component, and increase general-purpose properties of the stick according to various types and sizes of components.

### [Solution to Problem]

This object is solved by the component supply device of claim 1.

According to the above structure, the plurality of the components smoothly and certainly are slid along the inclination of the stick by the own weight and pressing force of the weight ball, and supplied to the component supply side.

According to the above structure, when the components of the stick become empty, the weight ball of the stick drops from the hole of the component supply route to the weight ball collection route, the sensor detects the weight ball, and thereby its signal that the stick has been emptied is quickly transmitted to a control section and the like.

Since the sensor is arranged in the weight ball collection route, the movement of the component in the component supply route is not prevented. Also, the replacing of the stick may be performed automatically, or by hand.

In the component supply device according to another aspect, the stick formed in a cross-sectional rectangular shape is inclined in a circumferential direction of the stick so that a bottom surface of the component and one side surface are supported with a bottom wall of the stick and one side wall of the stick. The cross-sectional surface of the stick is configured larger than the cross-sectional surface of the component, and the stick has general-purpose properties according to the type of the component.

According to the above structure of the present invention, the bottom surface of the components are supported by the inner surface of the inclined bottom wall of the stick regardless of the size of the component, and one of the side surfaces of the components is supported by the inner surface of the inclined one side wall of the stick, and the component is stably supported by crossing two surfaces without position gap in the vertical and horizontal directions. For example, by inclining the component supply device of the first, second and third aspects of the present invention in whole, it can be easy to achieve the structure of the fourth aspect of the present invention.

The object of the present invention is also solved by the component supply method according to claim 3.

According to the above structure, the plurality of the components are smoothly and reliably slid along the inclination of the stick, and supplied to the component supply side. Furthermore, when the components of the stick has became empty, the weight ball of the stick drops from the hole of the component supply route to the weight ball collection route, the sensor detects the weight ball, and thereby information that the stick has became empty is quickly transmitted to a control section and so on. Since the sensor is arranged in the weight ball collection route, the movement of the components in the component supply route is not prevented. Furthermore, when all of the components of the bottom stick are sent to the component supply route, and the bottom stick becomes empty, the weight ball in the bottom stick is detected by the sensor in the weight ball collection route. Based on the signal of the sensor, all of the sticks are lowered down to one tier by the lifting and lowering device. The bottom stick is removed from the component supply route downward, the second stick from the bottom is connected to the component supply route, and the components of the second stick are continuously sent to the component supply route by the own weight and pressing force of the weight ball.

### [Advantageous Effects of Invention]

According to the present invention, by using the weight ball, it is not necessary to use conventional air pressure. In addition, since the weight ball is received in one stick, space can be saved. Thus, the structure of the device can be simplified, and the size and costs of the device can be reduced.

Since the end of the weigh ball in the stick is detected by the sensor in the weight ball collection route, the movement of the component in the component supply route is not prevented, and it is possible to quickly and reliably detect that the stick becomes empty, and to efficiently replace the emptied stick with the stick receiving the component.

The components can be stably supported by two surfaces in the stick. Furthermore, whether the component is small or large, one type of the stick can be commonly used, and thereby the versatility of the stick can be increased.

By using the weight ball, it is not necessary to use conventional air pressure. In addition, since the weight ball is received in one stick, space can be saved. Thus, the structure of the device can be simplified, and the size and costs of the device can be reduced. Furthermore, since the end of the weigh ball in the stick is detected by the sensor in the weight ball collection route, the movement of the component in the component supply route is not prevented, and it is possible to quickly and reliably detect that the stick becomes empty, and to efficiently replace the emptied stick with the stick receiving the component. Additionally, the emptied bottom stick arranged with multiple tiers is moved downward, and the second stick receiving the components is moved to the bottom tier. As a result, the replacing of the stick can be automatically efficiently and quickly performed, and thereby supply of the components can be smoothly and continuously performed.

### [Brief Description of Drawings]

FIG. 1 is a side view showing an embodiment of a component supply device according to the present invention.
FIG. 2 is a side view showing a component supply method in a state that a bottom stick is empty in the component supply device.
FIG. 3 is a side view showing the component supply method in a state that the stick is replaced in the component supply device.
FIG. 4 is a front view showing the other embodiment of the present invention.

### [Description of Embodiments]

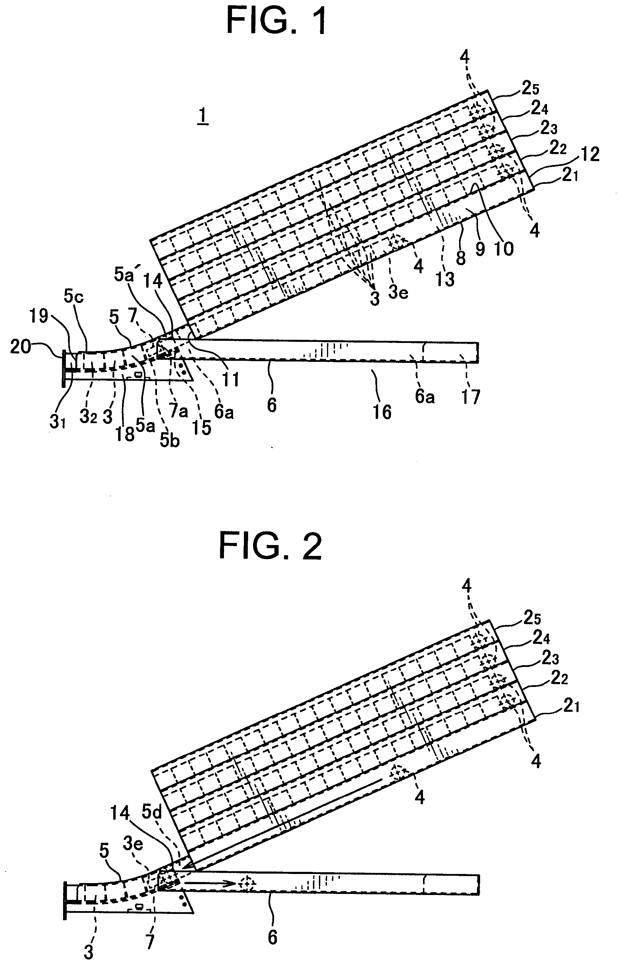

FIGS. 1 to 3 show one embodiment of a component supply device and a component supply method in the present invention.

As shown in FIG. 1, a component supply device 1 is inclined forward and downward. The component supply device 1 has hollow sticks 2 (2₁-2₅) for receiving components which is laminated with multiple tiers, a plurality of connector housings 3 made of synthetic resin as the components received in each the stick 2, a weight ball 4 movably arranged next to the back end of the bottom connector housing 3 in each the stick 2 and made of metal such as stainless assisting falling of the connector housing 3 at a slope of the stick 2, a component supply route 5 connecting to a front of the bottom stick 2₁ at a slant or curvature, a weight ball collection route 6 intersecting with the component supply route 5 close to the front end of the bottom stick 2₁ and inclined downward and backward, and a proximity sensor (weight detecting sensor) 7 for detecting the weight ball. The proximity sensor 7 is arranged in a intersecting portion of the component supply route 5 with the weight ball collection route 6 or near the intersection portion.

Each of the stick 2 is made of synthetic resin material, formed in a rectangular rolled shape with a bottom wall 8 laterally extending, both side walls 9, and an upper wall 10, and has openings 11 and 12 in the front end and the back end. Each of the openings 11, 12 is formed with the same horizontal and vertical size as a size between component receiving spaces 13 surrounded by the bottom wall 8, the both side walls 9, and the upper wall 10. For this reason, the stick 2 is able to be used regardless of a position of the front and back thereof. Preferably, the upper wall 10 has a slit (not shown) of a longitudinal direction in the center of the width direction so as to look at the components. If a fall of the connector housing 3 or the weight ball 4 have no worries, it is possible to eliminate the upper wall 10 and form the stick 2 in a concave shape of a cross-section. In addition, the stick 2 can be formed with metal material such as aluminum having a smoothly surface.

The component receiving space 13 arranged in the stick 2 is formed wider than the connector housing 3 in longitudinal and laterally directions, and slides and smoothly drops the connector housing 3. The inclination angle when the stick 2 is horizontally positioned is 20° to 25° degree. Since the weight ball 4 is used, the component supply device is controlled with a relatively-gentle inclination so as to lower the height of the component supply device. The length of each stick 2 of the embodiment is a length which can receive the connector housing 3, for example twenty connector housings 3, in series.

For example, a worker holds the stick 2 with both hands, and inclines it forward and downward. In a case that the opening 11 is blocked with his left hand, each connector housing 3 is inserted from the opening 12 arranged in the back end into the stick 2, and finally the weight ball 4 is inserted. Thereafter, the stick 2 in which the connector housing 3 and the weight ball 4 are inserted is set to a device main body (not shown).

Furthermore, the opening 12 of the back end may be narrowed against the weight ball 4 as a stopper. Further, a worker may hold and incline the stick 2 backward and downward, and insert the weight ball 4 and each connector housing 3 into the stick 2 from the wide opening 11 of the front end in order. The stick 2 may be called a rectangular tube body or component receiving tube. The shape of each connector housing 3 is the same size in a general rectangular shape. However, when a circular or trapezoidal connector housing is used, the stick 2 is formed in a tubular body according to the shape of the connector housing 3.

The weight ball 4 is a stainless-steel ball and heavier more than the connector housing 3. Furthermore, the outer diameter of the weight ball 4 is formed smaller than the length of the connector housing 3 in a longitudinal direction and the height thereof in a vertical direction. The outer diameter of the weight ball 4 may be the same as the width of the connector housing 3 in a horizontal direction. The weight ball 4 assists gravity feed of the connector housing 3 along the inner surface of the inclined stick 2.

The device main body (not shown) includes a metallic frame, laminates each stick 2, and maintains an inclined state. The inclined component supply route 5 is connected or projected in the front end of the frame. The frame has a bottom portion inclined along the bottom stick 2₁ of FIG. 1, and front and back wall portions inclined forward along the front and back ends of the stick 2. The frame has a bottom portion inclined along the bottom stick 2₁ (stick of bottom tier) of FIG. 1, and front and back wall portions inclined forward along the front and back ends of the stick 2. The front wall of the frame blocks the front opening 11 of each stick 2₂-2₅ of more than the second tier, and prevents an escape of the connector housing 3 from the front opening 11. Each stick 2 can decline along the frame step by step by a lifting device (not shown) of an air cylinder of the device main body. A positioning holding of the stick 2 in the frame 2 is performed by a holding means (not shown). The device main body will be suggested in another application in detail.

In FIG. 1, the inclined component supply route 5 has a square hole 14 for dropping the weight ball or opening on one side wall 5a in a portion crossing the weight ball collection route 6. The size of the hole 14 is set and formed smaller than the length of the connector housing 3 and the height thereof so as to not catch or enter the connector housing 3 in the hole 14. The lower end of the hole 14 is positioned in plane with the inner surface of the bottom wall 5b of the component supply route 5, and a part 5a' of the side wall 5a of the component supply route 5 remains at an upper side of the upper end of the hole 14. For this reason, the front end of the connector housing 3 is not caught in the hole 14, and thereby the connector housing 3 slide along the component supply route 5 smoothly.

In FIG. 1, when the last connector housing 3e in the bottom stick 2₁ passes through the hole 14 as shown in FIG. 2 (when the back end surface of the last connector housing 3e is positioned in plane with the front end of the hole 14), the weight ball 4 of the bottom stick 2₁ is entered into the hole 14. In the bottom wall 5b of the component supply route 5 connecting to the lower end of the hole 14, a inclined surface 15 for guiding the weight ball may be formed toward a opening (using reference number 14) of the weight ball collection route 6 to a obliquely downward direction so as to reliably drop the weight ball 4 from the hole 14 to the lateral weight ball collection route 6.

The width of the inclined surface 15 in the longitudinal direction is the same as the width of the hole 14 in the longitudinal direction. Preferably, the width of the inclined surface 15 in the horizontal direction is smaller than the width of the component supply route 5 in the horizontal direction so as to smoothly pass the connector housing 3 through the component supply route 5 without catching on an uneven surface occurring from the inclined surface 15. The hole 14 is located at the side wall 5a of the component supply route 5, but it is able to be located at the bottom wall 5b.

The weight ball collection route 6 is connected to the hole 14 of the component supply route 5, inclined in a direction opposite to a direction in which the component supply route 5 is inclined at an angle much smaller than an inclination angle of the stick 2 (at a nearly-horizontal angle), and linearly extends from the hole 14 backward. The weight ball collection route 6 is positioned in the lower side of either side of the stick 2 not under the stick 2 instead of just under the stick 2. Under the bottom stick 2₁ of FIG. 1, a space 16 is arranged in the frame at one side of the weight ball collection route 6 so as to move the used empty stick 2 down.

For example, the weight ball collection route 6 is formed in U-shape in cross-section, the opening connected to the hole 14 is formed with a size being equal to or larger than the hole 14 in one side wall 6a of the front end, and a opening 17 is arranged in the side wall 6a of the back end so as to discharge the weight ball 4 outside. When the opening 17 of the back end is not arranged, the weight ball collection route 6 is removable type as well as the stick 2, and the weight ball 4 is collected by removing the weight ball collection route 6 from the frame. The front end of the weight ball collection route 6 is located in a little front from the front end of the bottom stick 2₁, and the back end of the weight ball collection route 6 is located in the same virtual vertical plane as the back end of a top stick 2₅.

A proximity sensor 7 is fixed to the front end (front wall) of the weight ball collection route 6 at one side of the hole 14. A detecting surface 7a arranged in the end of the proximity sensor 7 is located beside the front end of the hole 14, and thereby the weight ball 4 rolling out of the weight ball collection route 6 from the hole 14 can be detected.

Preferably, the proximity sensor 7 is a magnetic proximity sensor in response to the metallic weight ball 4. However, for example, when the weigh ball 4 is made of heavy non-metal, or when a resin layer is coated on the surface of the metallic weight ball 4, it is possible to use a capacitance type proximity sensor 7.

A function of the proximity sensor 7 is to detect that the bottom stick 2₁ become empty. In place of the proximity sensor 7, it is possible to use a light sensor or a lever contact-type on-off switch (sensor) and the like. Furthermore, an installation location of the proximity sensor 7 is not limited near the hole 14. The proximity sensor 7 may be located in the side wall 6a of the weight ball collection route 6 behind the hole 14.

When the proximity sensor 7 is located midway in the weigh ball collection route 6, time lag might occur in detection. As a result, there is a worry that the detection of upper weight ball 4 can not be performed when all the weight balls 4 are received in the weight ball collection route 6. Thus, it is desirable that the proximity sensor 7 is located near the hole 14 as much as possible. Since the proximity sensor 7 is not arranged in the component supply route 5, the connector housing 3 passes the component supply route 5 smoothly without causing interference with the proximity sensor 7.

The component supply route 5 is formed in a U-shape in cross section with the curved bottom wall 5b and right and left side walls 5a. For example, the component supply route 5 is fixed in a vertical side wall 18 being a part of the frame. The back end of the component supply route 5 is inclined, and communicates with the opening 11 of the front end of the bottom stick 2₁. That is, the back end of the component supply route 5 abuts on the front end of the bottom stick 2₁.

A front portion 5c of the component supply route 5 is horizontally positioned. In the front portion 5c, the right and left side walls 5a is notched, and a notched portion 19 is formed. In the notched portion 19, the right and left side walls 5a of the connector housing 3₁ are exposed. In the notched portion 19, for example, the connector housing 3₁ is gripped with a chuck (not shown), lifted, and then transferred to next process. In the front end of the component supply route 5, a stopper wall 20 perpendicular to the first connector housing 3₁ is arranged. The connector housing 3 of the embodiment of the present invention is transferred to a terminal inserting process of next process in a state that the wide opening of a terminal receiving chamber is kept forward (a position that a terminal is inserted from the wide opening). The terminal with electric wire is inserted into the connector housing 3, and the connector is constructed.

Action of the component supply device 1, that is, a component supply method will be explained with reference to FIGS 1 to 3 below.

In an example of FIG. 1, the stick 2 in which the connector housing 3 is inserted is laminated with five tiers. The laminated number of the stick 2 may be more than five steps if the frame of device main body becomes high. Several connector housings 3 in the bottom stick 2₁ are already sent to the component supply route 5, and the first connector housing 3₁ abuts on the stopper wall 20 of the front end of the component supply route 5. A sending operation of the connector housing 3 in the stick 2 is performed by the weight of the connector housing 3 and a force pressing the connector housing 3 forward with the weight of the weight ball 4. A plurality of connector housings 3 are sent from the stick 2₁ to the stopper wall 20 of the front end of the component supply route 5 in series in a state that the front end and the back end are closely connected to each other in the longitudinal direction.

In a state of FIG. 1, the first connector housing 3₁ is supplied to the next process with a chuck (not shown). At the same time, each connector housing 3 slides forward by the weight and the action of the weight ball 4, and the connector housing 3₂ being second from the front abuts on the stopper wall 20. In the same manner, the connector housing 3 is sent to the next process with the chuck one by one. The weight ball 4 presses and abuts on a back end surface of the last connector housing 3e at all times.

As shown in FIG. 2, the bottom (first) stick 2₁ becomes empty, and the connector housing 3 is positioned in the component supply route 5 connected to the front of the bottom stick 2₁. The end of the connector housing 3e in the component supply route 5 passes the hole 14 for collecting the weight ball, and the weight ball 4 is positioned in the hole 14 having contact with the back end of the end of the connector housing 3e. At the same time, the weight ball 4 rolls down from the hole 14 to the weight ball collection route 6, simultaneously the proximity sensor 7 detects the weight ball 4, and information that bottom stick 2₁ is empty is transmitted to a control section (not shown).

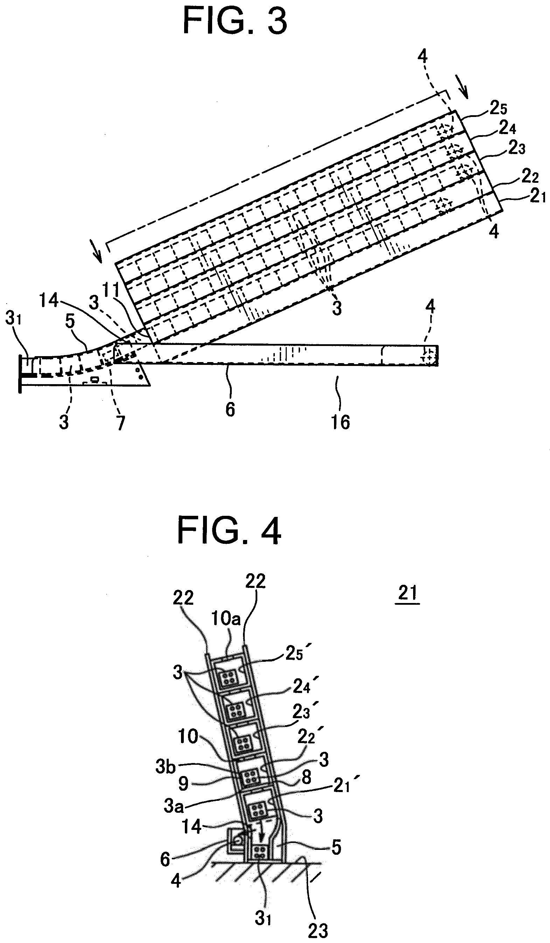

The control section provides instructions to the lifting and lowering device (not shown) and a holding device (not shown) arranged in the device main body. As shown in FIG. 3, the lifting and lowering device lowers all the sticks 2 (2₁-2₅) to one tier of the stick, and the stick 2₁ of the first tier emptied is moved down lower than the component supply route 5. The holding device releases holding of the bottom stick 2₁, and is moved to a collection space 16 arranged in the lower side of the frame to drop the bottom stick 2₁.

The second stick 2₂ from the bottom in FIG. 2 is the bottom stick in FIG. 3, and the opening 11 arranged in the front end of the bottom stick 2₂ communicates with an opening arranged in the back end of the component supply route 5. The connector housing 3 in the bottom stick 2₂ is sent to the component supply route 5 by both the weight of the connector housing 3 and pressing force of the weight ball 4. In an end space 5d of the empty component supply route 5 in FIG. 2, new connector housing 3 is replenished.

As shown in FIG. 3, between the front end of the component supply route 5 and the weight ball 4 arranged in the back portion of the bottom stick 2₂, each connector housing 3 is tightly positioned in the longitudinal direction in close contact with each other. The front end of the connector housing 3₁ in the component supply route 5 in FIG. 3 is conveyed to next process by a chuck. At the same time, the connector housing 3 in the bottom stick 2₂ is pressed by the weight ball 4, and thereby moved toward the component supply route 5.

In FIG. 3, when the bottom (second) stick 2₂ becomes empty after repeating movement of FIGS. 1 and 2, the bottom stick 2₂ falls into the collection space 16 located in the bottom. In the same manner, the other three sticks 2₃ - 2₅ send the connector housing 3 to the component supply rout 5, and all of the connector housings 3 are continuously supplied to next process.

When all of the sticks 2 (2₁ - 2₅) have fell into the collection space 16, several connector housing 3 remains in the component supply route 5. However, by again laminating and arranging the stick 2 in which the connector housing 3 is newly loaded in the frame, the connector housing 3 of the component supply route 5 is pressed forward in the connector housing 3 of the bottom stick 2₁, and can be supplied to next process. Furthermore, the last several connector housings 3 may be moved to the front end of the component supply route 5 by a hand of a worker.

In the embodiment of FIGS. 1-3, the sizes of the stick 2 or component supply route 5 can be changed based on the type or size of the connector housing 3. However, as the component supply device 21 shown in FIG. 4, for example, by including each stick 2' (2₁' - 2₅') at an angle in a front vision, that is, by tilting each stick 2' in a circumferential direction, it is possible to correspond to various types or sizes of the connector housing 3 being equal to or smaller than the cross-sectional shape of the stick 2'.

The bottom wall 3a and one side wall 3b of the connector housing 3 are supported by both the inner surface of the bottom wall 8 of the stick 2' and the inner surface of either side wall 9. In common with the stick 2', the component supply route 5 can be inclined in front vision and used. In this case, by inclining and using the component supply device 1 of FIG. 1 in whole, it is possible to perform. The cross-section of each stick 2' is formed larger than the cross-section of the connector housing 2.

In the embodiment of FIG. 4, the component supply route 5 is bent from the bottom stick 2₁' in the front vision, and the connector housing 3₁ is horizontally located in the front of the component supply route 5. The weight ball 4 rolls from the bottom stick 2₁' in a tilting direction of the stick 2' (the direction in which the connector housing 3 is inclined by the own weight) in the front vision, and is collected in the weight ball collection route 6 from the opening 14 of the side portion.

In FIG. 4, the reference number 10 indicates the upper wall of the stick, the reference number 10a indicates the slit in the center of the upper wall, the reference number 22 indicates the side wall of the frame, and the reference number 23 indicates the flat base of the frame. Furthermore, an illustration of the sensor 7 shown in FIG. 1 is not omitted. The structure shown in FIG. 4 is effective not only as the component supply device 21 but also the component supply method.

Also, in each embodiment of FIGS. 1 to 4, the stick 2 is laminated with multiple tiers, however it is not limited. For example, a relatively low-volume production case may arrange stick 2 in one tier, supply the connector housing 3 in the stick 2, and detect the weight ball 4 in the stick 2 by the sensor 4. At this time, according to the annunciation signal, the stick 2 can be pulled out by a worker, and the stick 2 in which new connector housing is inserted can be replaced.

In each embodiment, the connector housing 3 is used as the component, but it is not limited thereto. For example, instead of the connector housing 3, a connector receiving a terminal for crimping an electric wire, relay, or a box-shaped fusible link may be used.

### [Industrial Applicability]

The component supply device and the component supply method according to the present invention can be used to continuously supply the connector housing to a terminal inserting process one by one in a manufacturing process such as the wiring harness.

### [Reference Signs List]

1, 21 component supply device
2 stick
2' stick
3 connector housing (component)
3a bottom surface
3b one side surface
4 weight ball
5 component supply route
6 weight ball collection route
7 proximity sensor (sensor)
8 bottom wall
9 one side wall
14 hole

## Claims

1. A component supply device (1) comprising:
a stick (2) continuously receiving a plurality of components (3), and inclined in a component supply direction, and
a component supply route (5) connected to the stick (2),
**characterized in that** the device further comprises
a weight ball (4) arranged in an end of the plurality of the components (3) in the stick (2), and pressing the plurality of the components (3) in the component supply direction, a weight ball collection route (6) connected to a hole (14) for collecting the weight ball (4), the hole (14) being arranged in the component supply route (5),and
a sensor (7) for detecting the weight ball (4), the sensor (7) being arranged in the weight ball collection route (6),
so that when the components of the stick (2) become empty, the weight ball (4) of the stick (2) drops from the hole (14) of the component supply route (5) to the weight ball collection route (6), the sensor (7) detects the weight ball (4), and thereby its signal that the stick (2) has been emptied is transmitted to a control section.

2. The component supply device as claimed in claim 1, wherein the stick (2) is cross-sectionally rectangular-shaped and inclined in a circumferential direction of the stick (2) so that a bottom surface of the component (3) and one side surface of the component (3) are supported with a bottom wall (8) of the stick and one side wall (9) of the stick, the cross-sectional surface of the stick is configured sufficiently larger than the cross-sectional surface of the component (3), and thereby the stick (2) has general-purpose properties depending on the type of the component (3).

3. A method for supplying components using a component supply device as claimed in claim 1 or 2 comprising the steps of:
continuously receiving a plurality of components (3) in a stick (2),
arranging a weight ball (4) in the end of the plurality of the components (3),
arranging the stick (2) with multiple tiers and inclining the multiple tiers stick in a component supply direction,
arranging a component supply route (5) connected to the bottom stick (2₁), crossing a weight ball collection route (6) with the component supply route (5),
arranging a sensor (7) in the weight ball collection route (6),
detecting the weight ball (4) by the sensor (7),
arranging a lifting and lowering device operated by a detecting signal of the sensor (7),
lowering the multiple tiers stick to one tier by the lifting and lowering device based on the detecting signal of the sensor (7), and
connecting the second stick (2₂) from the bottom to the component supply route (5).

## Patentansprüche

1. Komponentenzuführvorrichtung (1), umfassend:
einen Stab (2), der fortlaufend eine Vielzahl von Komponenten (3) aufnimmt und in einer Komponentenzuführungsrichtung geneigt ist, und
einen Komponentenzufuhrweg (5), der mit dem Stab (2) verbunden ist,
**dadurch gekennzeichnet, dass** die Vorrichtung ferner umfasst:
eine Gewichtskugel (4), die an einem Ende der Vielzahl der Komponenten (3) in dem Stab (2) angeordnet ist und die Vielzahl der Komponenten (3) in der Komponentenzuführungsrichtung drückt,
eine Gewichtskugel-Sammelstrecke (6), die mit einer Bohrung (14) zum Sammeln der Gewichtskugel (4) verbunden ist, wobei die Bohrung (14) in dem Komponentenzufuhrweg (5) angeordnet ist, und
einen Sensor (7) zum Erfassen der Gewichtskugel (4), wobei der Sensor (7) in der Gewichtskugel-Sammelstrecke (6) angeordnet ist,
so dass, wenn die Komponenten des Stabes (2) leer werden, die Gewichtskugel (4) des Stabes (2) aus der Bohrung (14) des Komponentenzufuhrwegs (5) auf die Gewichtskugel-Sammelstrecke (6) fällt, der Sensor (7) die Gewichtskugel (4) erfasst und sein Signal, dass der Stab (2) entleert wurde, an einen Steuerabschnitt überträgt.

2. Komponentenzuführvorrichtung nach Anspruch 1, wobei der Stab (2) im Querschnitt rechteckig ausgebildet ist und in einer Umfangsrichtung des Stabes (2) geneigt ist, so dass eine Unterseite der Komponente (3) und eine Seitenfläche der Komponente (3) durch eine Bodenwand (8) des Stabes und eine Seitenwand (9) des Stabes gehalten werden, die Querschnittsfläche des Stabes ausreichend größer als die Querschnittsfläche der Komponente (3) ausgebildet ist und somit der Stab (2) je nach Art der Komponente (3) Mehrzweckeigenschaften aufweist.

3. Verfahren zum Zuführen von Komponenten unter Verwendung einer Komponentenzuführvorrichtung nach Anspruch 1 oder 2, mit den Schritten:
fortlaufendes Empfangen einer Vielzahl von Komponenten (3) in einem Stab (2),
Anordnen einer Gewichtskugel (4) am Ende der Vielzahl der Komponenten (3),
Anordnen des Stabes (2), der mehrere Reihen aufweist, und Neigen des mehrreihigen Stabes in einer Komponentenzuführrichtung,
Anordnen eines Komponentenzufuhrweges (5), der mit der unteren Reihe (2₁) verbunden ist,
Kreuzen einer Gewichtskugel-Sammelstrecke (6) mit dem Komponentenzufuhrweg (5),
Anordnen eines Sensors (7) in der Gewichtskugel-Sammelstrecke (6),
Erfassen der Gewichtskugel (4) durch den Sensor (7),
Anordnen einer Hebe- und Senkvorrichtung, die durch ein Detektionssignal des Sensors (7) betätigt wird,
Absenken des mehrreihigen Stabes auf eine Reihe durch die Hebe- und Senkvorrichtung auf der Grundlage des Erfassungssignals des Sensors (7), und
Verbinden des zweiten Stabes (2₂) von unten mit dem Komponentenzufuhrweg (5).

## Revendications

1. Dispositif d'amenée de composants (1) comportant :
une tige (2) recevant continuellement une pluralité de composants (3) et inclinée dans une direction d'amenée des composants, et
une voie d'amenée des composants (5) reliée à la tige (2),
**caractérisé en ce que** le dispositif comporte en outre
un poids en boule (4) agencé à une extrémité de la pluralité de composants (3) dans la tige (2) et pressant la pluralité de composants (3) dans la direction d'amenée des composants, une voie de récupération du poids en boule (6) reliée à un trou (14) pour récupérer le poids en boule (4), le trou (14) étant agencé dans la voie d'amenée des composants (5), et
un capteur (7) pour détecter le poids en boule (4), le capteur (7) étant agencé dans la voie de récupération du poids en boule (6),
de sorte que quand la tige est vidée de ses composants (2), le poids en boule (4) de la tige (2) tombe par le trou (14) de la voie d'amenée des composants (5) dans la voie de récupération du poids en boule (6), le capteur (7) détecte le poids en boule (4), et son signal indiquant que la tige (2) a été vidée est transmis à une section de commande.

2. Dispositif d'amenée de composants selon la revendication 1, où la tige (2) présente une section transversale de forme rectangulaire et est inclinée dans une direction circonférentielle de la tige (2) de telle manière qu'une surface inférieure du composant (3) et une surface latérale du composant (3) sont soutenues par une paroi inférieure (8) de la tige et une paroi latérale (9) de la tige, la superficie de la section transversale de la tige est configurée de manière à être suffisamment plus grande que la superficie de la section transversale du composant (3), et la tige (2) présente ainsi des propriétés générales en fonction du type de composant (3).

3. Procédé d'amenée de composants utilisant le dispositif d'amenée de composants selon les revendications 1 ou 2 comportant les étapes consistant à :
recevoir continuellement une pluralité de composants (3) dans une tige (2),
prévoir un poids en boule (4) à l'extrémité de la pluralité de composants (3),
prévoir plusieurs étages dans la tige (2) et incliner la tige à plusieurs étages dans une direction d'amenée des composants,
prévoir une voie d'amenée des composants (5) reliée à la tige (2₁), une voie de récupération du poids en boule (6) croisant la voie d'amenée des composants (5),
prévoir un capteur (7) dans la voie de récupération du poids en boule (6) détecter le poids en boule (4) au moyen du capteur (7),
prévoir un dispositif de levée et d'abaissement actionné par un signal de détection du capteur (7),
abaisser d'un étage la tige à plusieurs étages au moyen du dispositif de levée et d'abaissement en se fondant sur le signal de détection du capteur (7), et
connecter la seconde tige (2₂) en partant du bas avec la voie d'amenée de composants (5).
